Europäisches Patentamt

European Patent Office

Office européen des brevets

(11) Veröffentlichungsnummer: 0 194 695

A1

(12) EUROPÄISCHE PATENTANMELDUNG

(21) Anmeldenummer: 86103428.8

(22) Anmeldetag: 14.03.86

(51) Int. Cl.⁴: G 01 R 1/073
G 01 R 31/28

(30) Priorität: 15.03.85 DE 3509452
19.03.85 DE 3509918
21.03.85 DE 3510285

(43) Veröffentlichungstag der Anmeldung:
17.09.86 Patentblatt 86/38

(84) Benannte Vertragsstaaten:
AT CH DE FR IT LI NL

(71) Anmelder: Feinmetall Gesellschaft mit beschränkter
Haftung
Zeppelinstrasse 2
D-7033 Herrenberg(DE)

(72) Erfinder: Krüger, Gustav, Dr.
Danziger Strasse 1
D-7033 Herrenberg(DE)

(72) Erfinder: Kullen, Johannes, Dipl.-Ing.
Forststrasse 22
D-7300 Esslingen(DE)

(72) Erfinder: Giringer, Klaus
Ehbühl 14
D-7033 Herrenberg(DE)

(74) Vertreter: König, Oskar, Dr.-Ing. Dipl.-Phys.
Klüpfelstrasse 6 Postfach 51
D-7000 Stuttgart 1(DE)

(54) Verfahren und Prüfadapter zum Kontaktieren von Bauelementen für Prüfzwecke.

(57) Verfahren zum Kontaktieren von Bauelementen (15) für
Prüfzwecke. An einem Prüfadapter (10) sind Kontaktstifte (9)
in fester räumlicher Beziehung zueinander zum seitlichen
Kontaktieren der Anschlußkontakte (14) von Bauelementen
(15) so angeordnet, daß ihre Längsrichtungen in Richtung (A)
der für dieses Kontaktieren der Anschlußkontakte stattfindenden Relativbewegung zwischen dem Prüfadapter (10)
und dem Bauelement verlaufen. Die Kontaktköpfe (31) dieser
Kontaktstifte (9) sind mittels sie aufweisenden oder tragenden elastisch biegsamen Schäften (30) quer zur Richtung
dieser Relativbewegung (A) beweglich.

FIG.2

5824

Feinmetall GmbH
7033 Herrenberg

**Verfahren und** Prüfadapter zum Kontaktieren von Bauelementen für Prüfzwecke.

Die Erfindung betrifft ein Verfahren gemäß dem Oberbegriff des Anspruches 1 sowie einen Prüfadapter zur
Durchführung dieses Verfahrens und einen Kontaktstift
für einen solchen Prüfadapter.

Vorzugsweise bezieht sich die Erfindung auf die Herstellung elektrischer Verbindungen zu Leadless
Bauelementen. Die Erfindung ist jedoch hierauf nicht
beschränkt, da sie auch der Herstellung elektrischer
Verbindungen zu Anschlußkontakten anderer elektrischer
und elektronischer Bauelemente für Prüfzwecke dienen
kann, wie sie ebenfalls an Leiterplatten oder dergl. angeordnet werden oder sind und bei denen es sich vorzugsweise
ebenfalls um miniaturisierte elektrische und elektronische
Bauelemente handeln kann, die mindestens jeweils
einen Anschlußkontakt aufweisen, zu dem elektrische
Verbindungen nach der Erfindung wie zu Leadless
Bauelementen hergestellt werden können.

Unter Leadless Bauelementen sind miniaturisierte
elektrische und elektronische Bauelemente ohne Anschlußdrähte für elektronische Schaltungen verstanden, die
ihrem Anschluß und ihrem Anlöten an weiterführende
Leiter, Buchsen oder dergl. dienende Anschlußkontakte
aufweisen, die so am sie tragenden Körper des Bauelementes angeordnet sind, daß sie seitlich, vorzugsweise in Richtung auf den Umfang des sie tragenden

5824

Körpers des Bauelementes zu, zugänglich sind. Unter Umfang dieses Körpers ist der die Oberseite und die Unterseite dieses Körpers verbindende Umfangsbereich verstanden. Die Unterseite des Körpers ist, wenn dieses Bauelement auf einem Träger, wie einer Leiterplatte oder dergl. montiert ist, seine der Leiterplatte zugewendete Seite und die Oberseite die von der Leiterplatte oder dergl. abgewendete Seite.

Ferner wird nachfolgend mit Träger jeweils ein Gegenstand bezeichnet, an dem mindestens ein ·

Bauelement befestigt ist oder wird, vorzugsweise mit seinen Anschlußkontakten angelötet wird. Bei diesem Gegenstand handelt es sich also bspw. um eine Leiterplatte, eine Dickschicht-Schaltung, eine sonstige, Leiterbahnen oder dergl. aufweisende Platine oder einen sonstigen Träger, an dem mindestens ein solches Bauelement an am Träger angeordnete Leiter und/oder sonstige elektrische Komponenten elektrisch angeschlossen ist oder wird. Und zwar werden die Anschlußkontakte solcher Bauelemente an Leiterbahnen oder sonstige elektrische Anschlußpunkte des Trägers zwecks elektrischem Anschluß des Bauelementes meist angelötet. Unter Leadless Bauelementen sind nun solche verstanden, deren Anschlußkontakte an der dem diese Anschlußkontakte tragenden Körper des Bauelementes zugewendeten Seite des betreffenden Trägers, d. h. an auf dieser Seite des Trägers befindliche weiterführende elektrische Leiter oder dergl. angeschlossen, vorzugsweise angelötet werden. Es handelt sich also um Bauelemente, deren Anschlußkontakte nicht als lange Drähte ausgebildet sind, sondern als Beine, wie bspw. die Beine bei SMDs, SMCs, MELFs, Flatpacks oder als Kontaktflächen, wie bspw. bei Chip Carriers, oder dergl. Dagegen werden Bauelemente, deren Anschlußkontakte als Draht-Anschlüsse ausgebildet sind, so an dem jeweiligen Träger

5824                              - 3 -

montiert, daß ihre Anschlußdrähte durch Löcher in dem
Träger hindurchgesteckt und auf der vor dem diese
Anschlußdrähte tragenden Körper des Bauelementes abgewendeten Rückseite des Trägers angelötet werden.
Falls Anschlußkontakte bildende Anschlußdrähte gegenüber der dem sie tragenden Körper des Bauelementes zugewendeten Seite des Trägers auch seitlich ausreichend
zugänglich sind oder mindestens einer dieser Anschlußdrähte seitlich ausreichend zugänglich ist, kann die
Erfindung auch für bzw. bei solchen Bauelementen Anwendung finden, ebenfalls dann, wenn solche Bauelemente
vor ihrer Montage geprüft werden.

Bei Leadless Bauelementen handelt es sich insbesondere
um Chips-Bauelemente, auch SMCs oder SMDs genannt
(Surface-Mounted Components oder Surface-Mounted
Devices), Flatpacks, Chip Carriers, MELFs, usw. Die
Erfindung bezieht sich vorzugsweise auf solche Leadless
Bauelemente, ohne jedoch hierauf beschränkt zu sein.

Bauelemente, auf deren Kontaktierung sich die Erfindung
bezieht, bilden bspw. elektrische Widerstände, Kondensatoren,
Induktivitäten, Heißleiter, Schalenkerne, Dioden, Transistoren,
integrierte Schaltungen usw.
Über Leadless Bauelemente ist bspw. in folgenden
Zeitschriften berichtet:

(1) Elektronik 21/21.10.1983, Sonderteil, S. 118-124;
(2) Markt & Technik, Nr. 18 v. 4. Mai 1984, S.65,68
(3) Markt & Technik, Nr. 41 v. 12.Okt.1984, S.87,88,90,92,94,
(4) Markt & Technik, Nr. 26 v. 29.Juni1984, S. 48.

Die Prüfung der Bauelemente kann bereits vor ihrer
Montage zweckmäßig sein, bspw. zur

5824

Eingangskontrolle. Aber auch nach erfolgter Montage auf einem Träger ist diese Prüfung wichtig, bspw. um ihr fehlerfreies Anlöten und ihre einwandfreie Funktion im Rahmen der betreffenden Schaltung zu prüfen.

Nach obiger Druckschrift (2), S. 65, ist eine direkte Kontaktierung der Bauelementanschlüsse weder bei Leadless Components noch bei Flatpacks möglich, so daß separate "Pads", üblicherweise direkt neben den Bauelementanschlüssen, zur Kontaktierung geschaffen werden. Dies reduziert jedoch die möglichen Packungsdichten. Nach der Druckschrift (3), S. 90, gilt es in der Branche als tabu, den Prüfstift direkt an einem SMD-Bauelement anzusetzen, da durch das Aufdrücken eines Prüfstiftes auch fehlerhafte Lötverbindungen als einwand- frei erscheinen, keramische Bauelemente druckempfind- lich sind und sich das Bauelement aufgrund von Verschiebungen vor dem Lötprozeß nicht immer genau placie- ren läßt. Man hat deshalb bisher zur Prüfung von auf Trägeroberflächen montierten Leadless Bauelementen, die auf dem Träger angeordneten, elektrische Leiter bildenden Pads mittels axial federnden Federkontaktstiften kontaktiert. Solche nur axial federnden Federkontaktstifte sind bspw. in der Druckschrift (3) auf S. 92 dargestellt. Solche axial federnden Federkontaktstifte sind auch baulich aufwendig. Bei mit Draht- anschlüssen versehenen, auf Trägern montierten Bauelementen hat man bisher zur Herstellung elektrischer Verbindungen zu ihnen für Prüfzwecke bisher die auf der vom Körper des Bauelementes abgewendeten Rückseite des Trägers befindlichen Anlötstellen ihrer Anschlußdrähte durch axial federnde Federkontaktstifte kontaktiert. Solche Federkontaktstifte werden auch umso

5824                    - 5 -

störanfälliger, je kleiner ihre Maximaldurchmesser
zwecks Verringerung der Rastermaße des Trägers,
wie der Leiterplatte oder dergl., vorgesehen werden.
Und zwar werden den Trägern   bzw. den Leadless
Bauelementen normalerweise Rastermaße zugeordnet, die
im allgemeinen nach dem derzeitigen Stand der Technik
von 0,01 Zoll bis 0,10 Zoll reichen. Die Abstände
der Mitten der an einer Umfangsseite des Bauelementes
angeordneten Anschlußkontakte können dann entsprechend
einem solchen Rastermaß vorgesehen sein. Je kleiner
das Rastermaß ist, um so kleiner müssen die Maximaldurchmesser der Federkontaktstifte sein und um so störanfälliger werden diese Federkontaktstifte, bzw. es
bereitet dann auch Schwierigkeiten, ausreichende Federkraft des Federkontaktstiftes zu erreichen. Und
zwar sollen die Federkräfte solcher Federkontaktstifte,
mit denen also ihre Kontaktspitzen an die Prüfstellen
axial angedrückt werden, im allgemeinen 50 bis 300 cN
für ausreichend sicheres Kontaktieren der betreffenden Prüfstelle (Lötstelle, Buchse usw.) betragen.

Es ist eine Aufgabe der Erfindung, ein Verfahren der
im Oberbegriff des Anspruches 1 genannten Art zu schaffen, welches auf einfache Weise  die Anschlußkontakte
solcher Bauelemente für Prüfzwecke zu kontaktieren ermöglicht.

Diese Aufgabe wird erfindungsgemäß durch das in Anspruch 1 angegebene Verfahren gelöst. Ein erfindungsgemäßer Prüfadapter zur Durchführung des Verfahrens ist in Anspruch 4 beschrieben und ein erfindungsgemäßer Kontaktstift Kontaktstift für einen solchen Prüfadapter Gegenstand des Anspruches 18.

Das erfindungsgemäße Verfahren läßt die bisher üblichen, nur zu Prüfzwecken auf dem Träger angeordneten Pads vollständig vermeiden, da die Anschlußkontakte von Leadless Bauelementen durch die Kontaktstifte direkt kontaktiert werden. Ferner kann die volle Anpreßkraft der Kontaktstifte die Anschlußkontakte in Richtung auf den sie tragenden Körper zu belasten, so daß bei der normalerweise vorliegenden, ungefähr zentralsymmetrischen Anordnung der Anschlußkontakte die resultierende Kraft sämtlicher Anpreßkräfte der Kontaktstifte auf den sie tragenden Körper klein und praktisch zu Null werden kann, was günstig ist. Auch sind die mit Kontaktstiften über die Anschlußkontakte auf die Lötstellen ausgeübten Kräfte viel kleiner, als wenn diese Lötstellen durch dabei ausschließlich axial federnde Federkontaktstifte direkt kontaktiert würden, was fehlerhafte Lötstellen leichter erkennen läßt. Ferner wird bei auf Trägern montierten Bauelementen der Träger durch die über die Anschlußkontakte von den Kontaktstiften auf ihn ausgeübten Kräfte weniger belastet, als wenn herkömmliche Pads durch axial federnde Federkontaktstifte belastet würden, so daß sich der Träger weniger durchbiegt, leichter zu halten ist und die Lötstellen des Trägers weniger stark beansprucht werden. Wenn Anschlußdrähte von Bauelementen kontaktiert werden, kann dies zweckmäßig an Bereichen der Anschlußdrähte erfolgen, die sich seitlich der sie tragenden Körper oder zwischen den sie tragenden Körpern und dem von ihnen durchdrungenen Träger befinden, so daß man nicht mehr ihre auf der Rückseite des Trägers befindlichen Lötstellen kontaktieren muß und damit auch bei gemischter Bestückung von Trägern mit Leadless Bauelementen und mit Bauelementen mit Draht-Anschlüssen, bei denen erforderlichenfalls ihre Körper im Abstand oberhalb des Trägers durch die Anschlußdrähte gehalten werden können, die direkte Kontaktierung der Anschlußkontakte aller solcher Bauelemente gegenüber derselben Seite des Trägers erfolgen kann, wogegen man bisher bei solcher gemischten Bestückung beide Seiten der Leiterplatte oder dergl. prüfen mußte, siehe (3), S. 94. Wegen Wegfalls der Pads auf dem Träger läßt sich auch die Packungsdichte der Leadless Bauelemente auf dem Träger erhöhen und so auch der Träger verkleinern.

Auch läßt sich das erfindungsgemäße Verfahren für die Prüfung von noch nicht auf Trägern montierten Bauelementen einsetzen, wobei dann die Bauelemente für das Kontaktieren durch die Kontaktstifte mittels eines Halters oder einer Haltevorrichtung geeignet zu halten sind.

An der Durchführung des erfindungsgemäßen Verfahrens mitwirkende Kontaktstifte können wesentlich einfachere, kostengünstigere und betriebssichere Bauart als nur axial federnde Federkontaktstifte erhalten, da sie keinen axial gleitbaren, federbelasteten Kolben aufzuweisen brauchen. Bei erfindungsgemäßen Kontaktstiften wird der Kontaktkopf federnd ausgelenkt. Der Kontaktstift kann hierfür mindestens eine Biegefeder aufweisen, die vorzugsweise gerade sein kann. Es ist jedoch auch möglich, einen Abschnitt oder Schaft des Kontaktstiftes als gekrümmte Biegefeder auszubilden, wenn dies aus irgendwelchen Gründen erwünscht sein sollte. Auch benötigen die Kontaktstifte keine gesonderten Rückstellfedern. Sie können problemlos mit kleineren Maximaldurchmessern als nur axial federnde Federkontaktstifte
ausgebildet werden, so daß sie auch zusätzlich zu ihren
sonstigen Vorteilen noch Verkleinerung der Mittenabstände von am Bauelement benachbart angeordneten Anschlußkontakten ermöglichen, also noch kleinere Rastermaße als bisher.

Alle diese Vorteile werden sogar unter erheblicher Verringerung der Kosten für die Kontaktstifte und den
Prüfadapter und unter Erhöhung der Betriebssicherheit
erreicht.

Das erfindungsgemäße Verfahren hat noch den weiteren
ebenfalls wichtigen Vorteil, daß es relativ große
Toleranzen der Plazierung und in gewissen Grenzen auch
Schrägstellung des Bauelementes auf dem Träger bzw.
an dem es für die Prüfung tragenden Halter oder der
Haltevorrichtung zuläßt.

Im allgemeinen ist es besonders zweckmäßig, vorzusehen,
daß der Kontaktkopf des Kontaktstiftes den Anschlußkontakt auf dessen, von dem ihn tragenden Körper des
Bauelementes abgewendeten Seite kontaktiert. In manchen
Fällen ist es jedoch auch denkbar, daß man vorsehen
kann, daß der Kontaktkopf den betreffenden Anschlußkontakt - bezogen auf die von dem ihn tragenden Körper
abgewendeten Vorderseite - an seiner linken oder rechten
Seite kontaktiert.

Der den Kontaktkopf des Kontaktstiftes aufweisende oder
tragende Schaft oder dergl. des Kontaktstiftes ist elastisch biegsam, wozu er durchgehend oder an mindestens
einer Stelle eine biegsame Feder bilden oder aufweisen kann, die die federnde Auslenkbarkeit des Kontaktkopfes ermöglicht oder mit ermöglicht. Der elastisch biegsame Schaft kann, aber braucht nicht durchgehend elastisch biegsam zu sein.

Die Kontaktstifte können vorzugsweise metallisch sein und durch Drehen aus geradem Federdraht hergestellt werden. Bevorzugt können sie aus Kupfer-Beryllium oder aus Palladiumlegierungen bestehen. Auch können sie noch oberflächenveredelt sein, bspw. vollständig oder bereichsweise mit Überzügen versehen sein, vorzugsweise aus Edelmetall oder auch aus anderen Stoffen. Bevorzugt können sie Härten von 300 bis 500 HV aufweisen.

Erfindungsgemäße Kontaktstifte können im ganzen rotationssymmetrisch sein, was ihre besonders einfache Herstellung durch Drehen aus geradem Federdraht ermöglicht. Oder es ist bei dieser Herstellungsart durch Drehen auch möglich, sie an einer oder mehreren Stellen auch noch zu fräsen oder zu schleifen, vorzugsweise dazu, um die in beim Kontaktieren von Bauelementen auftretender Biegerichtung gemessene Dicke des Kontaktkopfes zu verringern, um hierdurch noch weniger Platz für den Kontaktkopf zu benötigen und so die Packungsdichte solcher Bauelemente auf dem Träger noch weiter vergrößeren zu können.

Damit guter Kontakt zwischen dem Kontaktkopf des Kontaktstiftes und dem betreffenden Anschlußkontakt des Bauelementes zustande kommt, muß die Andrückkraft des Kontaktstiftes an den jeweiligen Anschlußkontakt ausreichend groß sein. Im allgemeinen können ca. 50 bis 300 cN Anpreßkraft infrage kommen. Solche Anpreßkräfte lassen sich mit erfindungsgemäßen Kontaktstiften problemlos durch entsprechende Dimensionierung des Schaftes erreichen. Der Schaft kann dabei vorzugsweise rotationssymmetrisch ausgebildet sein, besonders zweckmäßig zylindrisch oder sich in Richtung auf den Kontaktkopf zu verjüngen . Es kommen jedoch auch andere Ausbildungen für den Schaft infrage. Bspw. kann er in manchen Fällen zweckmäßig als Blattfeder ausgebildet sein oder eine Blattfeder aufweisen. Dies kann zwar den Kontaktstift verteuern,da dann zweckmäßig die Blattfeder an einem in eine Aufnahmebohrung einer Trägerplatte des Prüfadapters formschlüssig einsetzbaren, stiftförmigen Fuß des Kontaktkopfes befestigt werden kann, doch ermöglicht die Blattfeder noch höhere Packungsdichten der Bauelemente und engere Toleranzen der Anpreßkräfte als ein durch Drehen hergestellter rotationssymmetrischer Schaft. Im Falle der Ausbildung des Schaftes als Blattfeder kann deren freier Endbereich oft vorteilhaft der dem Kontaktieren der Anschlußkontakte von Bauelementen dienende Kontaktkopf sein. Bevorzugt kann dann dieser freie Endbereich geeignet gebogen sein, bspw. zweckmäßig V-förmig mit querliegendem V. Es ist jedoch auch möglich, an der Blattfeder einen als gesondertes Teil ausgebildeten Kontaktkopf zu befestigen, bspw. anzuschweißen.

Bevorzugt kann vorgesehen sein, daß der Kontaktkopf des Kontaktstiftes über den angrenzenden Schaft in Richtung auf den zu kontaktierenden Anschlußkontakt eines Bauelementes vorspringt, was größere Ausbiegungen des Schaftes und größere Toleranzen zuläßt. Ggfs. ist es jedoch auch in manchen Fällen möglich, den Kontaktkopf als nicht verdickten bzw. nicht verbreiterten freien Endbereich des Schaftes vorzusehen.

5824

In der Zeichnung sind Ausführungsbeispiele der Erfindung dargestellt. Es zeigen:

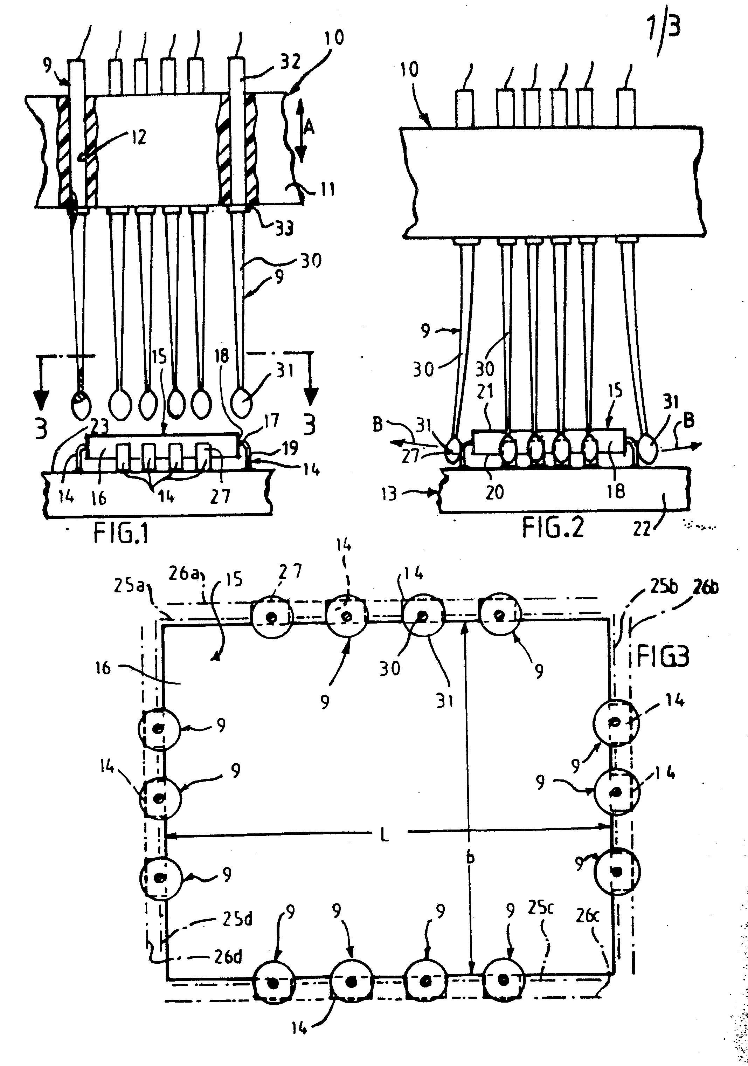

Fig. 1 und 2   je eine ausschnittsweise und teilweise gebrochene Seitenansicht eines Prüfadapters und eines eine bestückte Leiterplatte bildenden Prüflings, wobei in Fig. 1 der Prüfadapter und die dargestellten Kontaktstifte gemäß einem Ausführungsbeispiel der Erfindung ausgebildet und diese Kontaktstifte am Prüfadapter in Art der Borsten einer Bürste angeordnet sind, wobei diese Kontaktstifte in Fig. 1 noch außer Kontakt mit dem durch sie direkt zu kontaktierenden Leadless Bauelement sind, dessen Anschlußkontakte auf der Leiterplatte an weiterführende Leiterbahnen oder dergl. angelötet sind, wogegen in Fig. 2 der Prüfadapter mit den Kontaktstiften in die Stellung vertikal nach unten bewegt ist, in der die Kontaktstifte die Anschlußkontakte des Bauelementes zur Durchführung einer Prüfung auf Fehlerfreiheit kontaktieren,

Fig. 3   einen Teilschnitt durch Fig. 1, gesehen entlang der Schnittlinie 3-3 der Fig. 1 in vergrößerter Darstellung,

Fig. 4 bis 11   in Seitenansicht gebrochen dargestellte Ausführungsformen von Kontaktstiften gemäß weiteren Ausführungsbeispielen der Erfindung, wobei bei den Fig. 4, 5, 7, 9 und 10 jeweils auch noch ein Leadless Bauelement und in Fig. 8 ein Bauelement mit Anschlußdrähten ausschnitts-

5324                         − 12 −

weise dargestellt ist, dessen jeweils zu sehender
Anschlußkontakt durch diesen Kontaktstift
durch dessen Abwärtsbewegung in die strichpunktiert dargestellte Stellung zu kontaktieren ist,

Fig. 4 A    Schnitte durch die Kontaktstifte der Fig. 4
bis  8 A    bis 8, gesehen entlang der Schnittlinien
            4 A − 4 A, 5 A − 5 A, 6 A − 6 A bzw. 7 A − 7 A
            und 8 A − 8 A.

In Fig. 1 ist ein Ausschnitt eines in Pfeilrichtung A
vertikal auf- und abbewegbaren Prüfadapters 10 geschnitten dargestellt, der eine Tragplatte 11 aus
elektrisch isolierendem Material mit einer Vielzahl
von zueinander parallelen, vertikalen Aufnahmebohrungen
12 für richtungsgleich angeordnete Kontaktstifte 9
aufweist. Die Aufnahmebohrungen 12 können bspw. Durchmesser von 0,2 bis 1,8 mm und in der jeweiligen Reihe
Mittenabstände von bspw. 0,3 bis 2,6 mm aufweisen.
Der Prüfadapter 10 dient dem Kontaktieren von Prüflingen, wie 13, um diese auf elektrische Fehlerfreiheit
zu prüfen.

Bei den dargestellten, parallel zueinander vertikal
angeordneten geraden Kontaktstiften 9 des Prüfadapters
10 handelt es sich um gemäß einem Ausführungsbeispiel
der Erfindung ausgebildete und angeordnete Kontaktstifte 9 zum jeweils gleichzeitigen seitlichen
Kontaktieren aller Anschlußkontakte 14 jeweils eines elektronischen oder elektrischen Bauelementes 15. Da solche Prüflinge 13 normalerweise noch zahlreiche andere solche  Bauelemente 15
tragen, können an dem Prüfadapter noch entsprechend
weitere Anordnungen solcher Kontaktstifte 9 zum
Kontaktieren dieser anderen Bauelemente angeordnet sein, desgleichen auch eine mehr oder weniger große Anzahl von herkömmlichen Kontaktstiften, wie
axial federnden Kontaktstiften und pneumatischen Kontaktstiften, zum Kontaktieren anderer Prüfstellen des
Prüflinges, wie Leiterbahnen, Lötstellen, Buchsen usw.

Bei dem durch die in den Fig. 1 bis 3 dargestellten
Kontaktstifte 9 zu kontaktierenden Bauelement 15 handelt es sich um ein Leadless-SMD-bzw. Leadless-SMC-
Bauelement. Dieses besteht aus einem quaderförmigen
Körper 16 und den seitlichen Anschlußkontakten 14.
Jeder der unter sich gleich ausgebildeten Anschlußkontakte 14 ragt mit einem kurzen, horizontalen Schenkel 17 in den Körper 16 an der zugeordneten schmalen
vertikalen ebenen Seitenfläche 18 des Körpers 16 hinein. An diesen kurzen Schenkel 17 schließt ein vertikal nach unten führender längerer Schenkel 19 an, die
bei allen Anschlußkontakten 14 zueinander parallel sind.
Diese langen geraden Schenkel 19 ragen nach unten über
die Unterseite 20 des Körpers 16 hinaus, welche ebene
Unterseite 20 parallel zur ebenen Oberseite 21 des
Körpers 16 ist. Diese Anschlußkontakte 14 bilden gleichzeitig Beine zum Tragen des Körpers 16. Diese Beine 14

bestehen aus lötfähigem Metall und sind an einem Träger 22, der hier eine Leiterplatte ist, an auf ihr aufgedruckten Leiterbahnen oder an sonstigen elektrischen Komponenten auf der der Unterseite 20 des Körpers 16 zugewendeten Breitseite 23 des Trägers 22 angelötet.

Am Prüfadapter 10 ist für jeden der Anschlußkontakte 14 je ein Kontaktstift 9 gemäß diesem Ausführungsbeispiel der Erfindung fest angeordnet. Diese Kontaktstifte 9 sind in diesem Ausführungsbeispiel unter sich gleich ausgebildet. Doch ist es auch möglich, unterschiedlich ausgebildete Kontaktstifte, bspw. unterschiedlich lange Kontaktstifte, vorzusehen, falls dies für das Kontaktieren der Anschlußkontakte zweckmäßig oder notwendig ist.

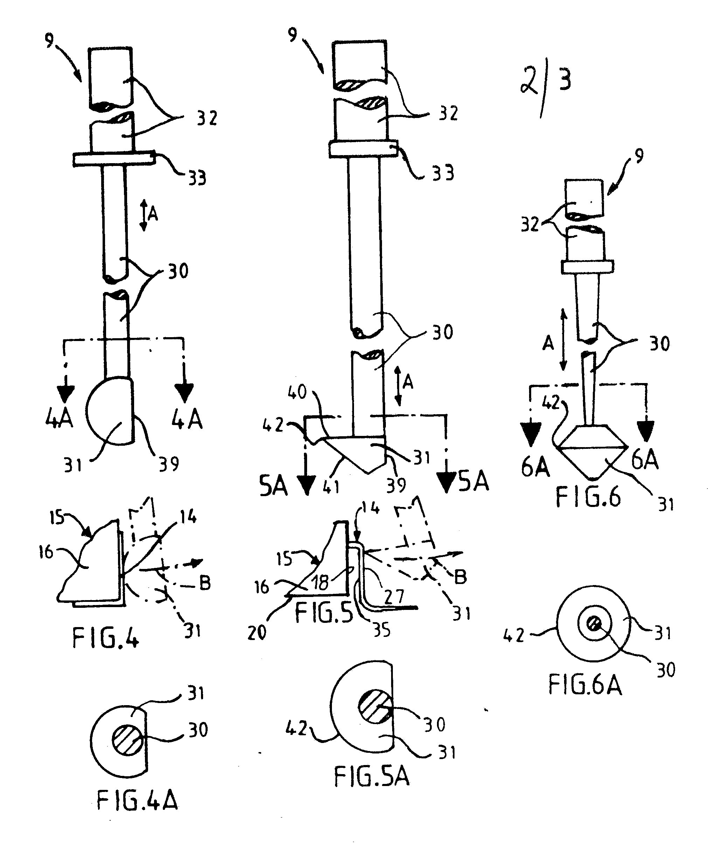

Diese Kontaktstifte sind wie Borsten einer Bürste an der Tragplatte 11 zueinander parallel fest angeordnet. Sie bilden auf diese Weise insgesamt vier gerade Reihen, die jeweils paarweise zueinander parallel angeordnet sind. In Fig. 3 sind die durch die Längsachsen der noch ungebogenen Kontaktstifte 9 definierten Reihenmittellinien bei 25a bis 25d dargestellt. Der Abstand der beiden zueinander parallelen Mittellinien 25b und 25d voneinander ist geringfügig größer als die Länge L des Körpers 16 und entsprechend ist der Abstand der Mittellinien 25a und 25c voneinander ebenfalls geringfügig größer als die Breite b des Körpers 16. Die Längsachsen der geraden Kontaktstifte 9 sind vertikal und parallel zur Bewegungsrichtung (Pfeil A) des Prüfadapters 10.

Ferner sind in Fig. 3 strichpunktiert gerade Linien 26a bis 26d eingezeichnet, wobei jede solche geometrische Linie durch die von dem Körper 16 abgewendeten, durch die Kontaktstifte 9 zu kontaktierenden, vertikalen, ebenen Außenseitenflächen 27 der Anschlußkontakte 14 definiert sind. Dabei ist der Abstand der beiden zueinander parallelen Linien 26a und 26c voneinander und auch der Abstand der ebenfalls zueinander parallelen Linien 26b und 26d um so vieles erheblich größer voneinander als die Abstände der Linien 25a und 25c bzw. 25b und 25d voneinander, daß es beim durch vertikales Abwärtsbewegen des Prüfadapters 10 aus der in Fig. 1 bis in die in Fig. 2 dargestellte Stellung erfolgenden Ausbiegen der federnden Schäfte 30 der Kontaktstifte 9 infolge des Inkontaktkommens der Kontaktköpfe 31 dieser Kontaktstifte 9 mit den Anschlußkontakten 14 bis in die in Fig.2 dargestellten Stellungen kommt, in denen die gerade, stabförmige Biegefedern bildenden Schäfte 30 gewünschte Anpreßkräfte der Kontaktköpfe 31 an die Flächen 27 ausüben.

Während in der Regel die Anschlußkontakte 14 eines solchen Leadless Bauelementes gemäß einem bestimmten Raster von bspw. 0,01 bis 0,1 Zoll angeordnet sind, gilt dieses Rastermaß dann wegen der erforderlichen Ausbiegung der Schäfte 30 beim Kontaktieren der Anschlußkontakte 14 nicht mehr immer für die jeweils zueinander parallelen Kontaktstiftreihen, also im allgemeinen nicht mehr für die Abstände zwischen den Linien 25a und 25c bzw. 25b und 25d zueinander. Ferner fluchten die Längsachsen der Aufnahmebohrungen 12 mit den Längsachsen der Kontaktstifte 9, so daß entsprechendes für die Aufnahmebohrungen 12 gilt, die die Kontaktstifte 9 dieser dem Kontaktieren des Bauelementes 15 dienenden Kontaktstiftanordnung aufnehmen. Dementsprechend sind auch die Aufnahmebohrungen 12 meist nicht
mehr durchgehend gemäß dem Rastermaß der Anschlußkontakte 14 angeordnet, wobei jedoch die Mittenabstände
der Kontaktstifte 9 der einzelnen Kontaktstiftreihe
entsprechend dem der Anordnung der Anschlußkontakte 14
entsprechenden Rastermaß angeordnet sein können.

Die Erfindung macht es also je nach Sachlage erforderlich, von einem einheitlichen Rastermaß bei den Aufnahmebohrungen 12 abzuweichen. Wenn man ein einheitliches Rastermaß beibehalten will, kann man jedoch
erforderlichenfalls auch vorsehen, die Schäfte 30
der Kontaktstifte 9 in entspanntem Zustand nicht gerade auszubilden, sondern schwach bogenförmig, bspw.
schwach S-förmig, so zu krümmen, daß zwar die Kontaktköpfe 31 nicht mehr in einem einheitlichen Rastermaß
angeordnet sind, jedoch die Aufnahmebohrungen 12 für
die Fußteile 32. Indem der Kontaktstift 9 rotationssymmetrisch und
allseitig auslenkbar ist, kann das Fußteil 32 in beliebiger Winkelstellung in die Bohrung 12 eingesetzt werden, was vorteilhaft ist.

Die Anordnung dieser Fußteile 32 und damit die Anordnung der von ihnen
formschlüssig durchdrungenen Aufnahmebohrungen 12 des Prüfadapters 10
ist, wie ersichtlich, so vorgesehen, daß die Kontaktköpfe 31 der Kontaktstifte 9 beim geraden Abwärtsbewegen des Prüfadapters 10 aus den in Fig. 1
dargestellten Stellungen in die in Fig. 2 dargestellten Stellungen unter seitlichem Auslenken  bewegt werden, in der die Prüfung des Prüflings 13 durchgeführt wird. Dieses seitliche Auslenken der Kontaktköpfe 31 erfolgt durch die Anschlußkontakte 14 und ggfs.
vor deren Erreichen noch durch die oberen Kanten des Körpers 16

quer zur Bewegungsrichtung (Pfeil A) des Prüfadapters 10 und damit auch quer zu den Längsrichtungen dieser Kontaktstifte 9 unter seitlichem Auslenken der federnden Schäfte 30. Für zwei Kontaktstifte 9 in Fig.2 sind diese bei der Abwärtsbewegung des Prüfadapters 10 stattfindenden Bewegungsrichtungen der Kontaktköpfe 31 durch die Pfeile B dargestellt.Da die Kontaktstifte 9 in geradem Zustand axial nicht federn, ist es wichtig,

daß es nicht zum Aufsetzen der unteren Enden der Kontaktköpfe auf die Oberseite 21 des Körpers 16 kommt, da in diesem Falle der betreffende Kontaktstift beim Abwärtsbewegen des Prüfadapters nicht seitlich auswandern würde, sondern es zur Zerstörung des Körpers 16 bzw. auch zur Beschädigung oder zur Zerstörung des betreffenden Kontaktstiftes 9 kommen kann. Die Kontaktstifte 9 sind also so anzuordnen, daß das Bauelement 15 stets nur mit Kontaktflächen der Kontaktköpfe 31 in Berührung kommen kann, die so schräg zu den durch sie zu kontaktierenden Flächen oder Kanten des Bauelementes 15 sind, daß es stets zum sicheren Auslenken der Kontaktköpfe 31 unter federndem Ausbiegen der Schäfte 30 in von der dem betreffenden Kontaktkopf jeweils benachbarten umfangsseitigen Seitenfläche 18 wegführender Richtung(Pfeil B) kommt, wie es Fig.2 zeigt.Diese federnde Ausbiegung des Schaftes 30 ist dabei so groß vorzusehen,daß der Kontaktkopf 31 in der Endstellung des Prüfadapters 10 (Fig. 2) mit ausreichend großer Kontaktkraft an dem betreffenden Anschlußkontakt 14 anliegt. Diese Kontaktkraft kann im allgemeinen zweckmäßig zwischen 50 und 300 cN liegen. Es wird selbst bei dem abgerundeten Kontaktkopf 31 guter zuverlässiger Kontakt zwischen ihm und dem Anschlußkontakt 14 erreicht, da er ab dem Inkontaktkommen mit dem Anschlußkontakt 14 auf diesem entlanggleitet, und diese gleitende Reibung läßt eventuelle Oxidschichten auf ihm besonders leicht durchdringen. Wenn dagegen der Anschlußkontakt 14 durch einen axial federnden, herkömmlichen Kontaktstift kontaktiert würde, würde dessen Kontaktspitze nicht auf dem Anschlußkontakt 14 gleiten, was weniger günstig für guten Kontakt als gleitende Reibung ist. Auch dies ist ein Vorteil der Kontaktstifte 9.

In diesem Ausführungsbeispiel ist der Kontaktkopf 31 wie auch der gesamte übrige Kontaktstift 9 in ungebogenem Zustand rotationssymmetrisch. Dieser gerade Kontaktstift weist das zylindrische Fußteil 32, den Schaft 30, den Kontaktkopf 31 und einen zwischen Schaft 30 und Fußteil 32 befindlichen Ringbund 33 auf. Der Ringbund 33 bildet einen Anschlag für den Kontaktstift 9 an der Tragplatte 11 des Prüfadapters 10 zur exakten axialen Positionierung des Kontaktstiftes 9. Das Fußteil 32 steht über die Rückseite der Tragplatte 11 über und bildet hier ein Anschlußende des Kontaktstiftes 9, an das ein zu einem Auswerter der Prüfvorrichtung führender elektrischer Leiter angeschlossen, bspw. angelötet ist. Das Fußteil 32 sitzt mit Haftreibung in der Aufnahmebohrung 12. Diese Reibung ist so groß, daß der Kontaktstift während des Betriebs nicht axial verschoben wird. Jedoch kann er von Hand oder maschinell aus der Aufnahmebohrung 12 herausgezogen und gegen einen anderen Kon-

taktstift ausgewechselt werden.

Der Schaft 30 des Kontaktstiftes 9 verjüngt sich zwecks besonders günstigen Federungseigenschaften vom Ringbund 33 aus bis zum Kontaktkopf 31 stetig, indem er kegelstumpfförmig gestaltet ist. Die hierdurch erzielte Verringerung des Durchmessers des Schaftes 30 in der Nähe des Kontaktkopfes 31 verhindert auch, daß dieser Schaft 30 in Berührung mit dem Körper 16 kommen kann. Falls solche Berührung stattfinden könnte, würde hierdurch der Kontakt zwischen dem Kontaktkopf 31 und dem Anschlußkontakt 14 verschlechtert oder ganz verhindert werden.

Der unmittelbar am vorderen Ende des Schaftes 30 fest angeordnete Kontaktkopf 31 hat in diesem Ausführungsbeispiel die ungefähre Gestalt eines Ellipsoids. Die Kontaktfläche dieses Kontaktkopfes ist derjenige Flächenbereich von ihm, der in Kontakt mit dem Anschlußkontakt 14 kommen kann. Es handelt sich also um einen schmalen Flächenbereich, der in der Stellung des Kontaktkopfes 31 gemäß Fig. 2 auf der dem Körper 16 zugewendeten Seite liegt und der die vom Körper 16 abgewendete Vorderseite 27 des Anschlußkontaktes 14 kontaktiert.

Wenn der Prüfadapter die in Fig. 2 dargestellte, unterste vertikale Stellung erreicht hat, wird seine Bewegung angehalten, und es wird dann die elektrische Prüfung der bestückten Leiterplatte, d.h. des Prüflings 13, auf elektrische Fehlerfreiheit mittels eines nicht dargestellten, an die elektrische Leiter bildenden Kontaktstifte, wie 9, des Prüfadapters angeschlossenen Auswerters ausgeführt. Die Kontaktstifte dienen dem Leiten von elektrischen Strömen bzw. Spannungen. Nach beendeter Prüfung wird der Prüfadapter wieder nach oben geführt und der Prüfling 13 gegen einen neuen Prüfling 13 ausgewechselt.

In den Ausführungsbeispielen nach den Fig. 4 bis 11 sind Varianten von Kontaktstiften 9 gebrochen und teilweise geschnitten dargestellt. Dabei sind in den Fig. 4,5,7,9 und 10 noch ausschnittsweise je ein Leadless Bauelement 15 und in Fig. 8 ein Bauelement 15 mit Drahtanschlüssen mit dargestellt, das durch den betreffenden Kontaktkopf 31 in der strichpunktierten Stellung kontaktiert wird. Auch diese Kontaktstifte 9 sind mittels der sie aufweisenden, nicht dargestellten Prüfadapter in Richtung der Doppelpfeile A auf- und abbewegbar. Bei den Abwärtsbewegungen werden dabei ihre Kontaktköpfe 31 durch die von ihnen kontaktierten Bauelemente 15 wieder sowohl quer zur vertikalen Abwärtsbewegungsrichtung des Prüfadapters als auch quer zur Längsrichtung des Kontaktstiftes 9 in Richtung der Pfeile B unter entsprechendem federnden Ausbiegen der Schäfte 30 bewegt.

Das Leadless Bauelement 15 ist in Fig. 4 ein Chip Carrier, dessen Anschlußkontakte durch je eine auf den Keramikkörper 16 aufgebrachte metallische Kontaktbahn 14 gebildet sind. Die metallische Kontaktbahn weist zwei Schenkel auf, von denen der eine Schenkel an einer Umfangsfläche 18 und der anderen Schenkel an der Unterseite 20 des Körpers 16 angeordnet ist. Der Kontaktkopf 31 dient dem Kontaktieren des an der Umfangsfläche 18 befindlichen Schenkels dieser Kontaktbahn 14.

In Fig. 5 ist das ausschnittsweise dargestellte Leadless Bauelement 15 ein Flatpack, dessen metallischer Anschlußkontakt 14 aus zwei vertikal zueinander versetzten horizontalen Schenkeln und einem diese beiden Schenkel verbindenden vertikalen geraden Mittelsteg 35 besteht. Dieser Mittelsteg verläuft parallel zur benachbarten Umfangsseite 18 und steht nach unten etwas über die Unterseite 20 des Körpers 16 dieses Bauelementes, wie dargestellt, über. Der Kontaktkopf 31 des Kontaktstiftes 9 dient dem Kontaktieren des seitlich der Umfangsseite 18 befindlichen, zu ihm parallelen Steges 35 auf der von dem Körper 16 abgewendeten Außenseite 27, wie es strichpunktiert dargestellt ist.

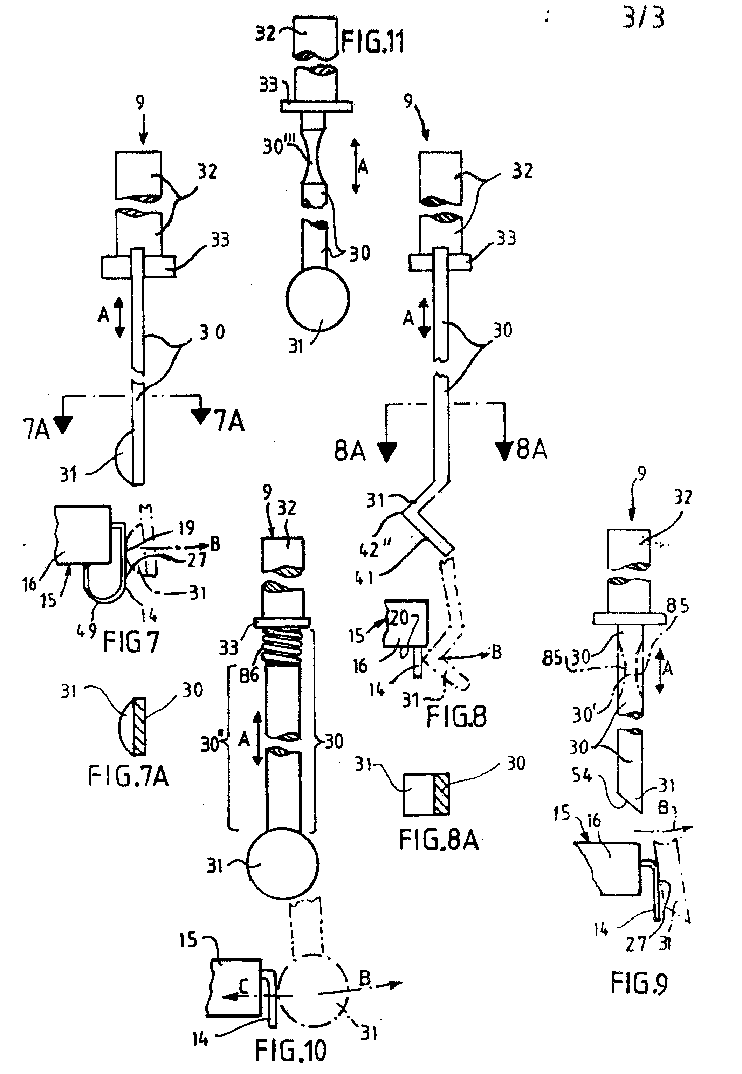

In Fig. 7 ist das ausschnittweise dargestellte Leadless Bauelement 15 ein SMD bzw. SMC, dessen dargestellter Anschlußkontakt 14 sich von dem Anschlußkontakt 14 des Bauelementes 15 nach der Fig. 1 nur dadurch unterscheidet, daß der vertikale Schenkel 19 untenseitig noch nach innen oben hakenförmig umgebogen bis zum Aufsitzen auf der Unterseite des Körpers 16 wie dargestellt weitergeführt ist. Die vom Körper 16 abgewendete Vorderseite 27 des vertikalen Schenkels 19 wird wie im Ausführungsbeispiel nach Fig. 1 bis 3 durch den Kontaktkopf 31 des Kontaktstiftes 9 kontaktiert.

In Fig. 8 weist das ausschnittsweise dargestellte Bauelement 15 Anschlußdrähte 14 als Anschlußkontakte auf, die an der Unterseite 20 seines Körpers 16 nahe ihres Randes angeordnet sind. Der zu sehende Anschlußdraht 14 wird vom abwärts bewegten Kontaktkopf 31, wie strichpunktiert dargestellt, kontaktiert.

Zunächst seien die in den Fig. 4 bis 6 dargestellten Kontaktstifte erläutert. Sie können zweckmäßig wiederum einstückig sein. Sie unterscheiden sich von dem Kon-taktstift 9 nach den Fig. 1 bis 3 in folgenden Details:

5824 — 22 —

In Fig. 4 und 5 ist der Schaft 30 nicht kegelstumpfförmig, sondern kreiszylindrisch.

Der Kontaktkopf 31 des Kontaktstiftes 9 nach Fig. 4
und 4 A unterscheidet sich von dem der Kontaktstifte 9 nach den Fig. 1 bis 3 im wesentlichen nur
dadurch, daß seine vom jeweils zu kontaktierenden Anschlußkontakt 14 abgewendete Rückseite 39 eben abgefräst
ist. Dieser Kontaktkopf war also ursprünglich rotationssymmetrisch und wurde dann rückseitig abgefräst, was herstellungstechnisch am günstigsten ist.
Durch diese Abfräsung wurde die Dicke des Kontaktkopfes in der Bildebene kleiner und hierdurch können
geringere Abstände zwischen benachbarten Leadless
Bauelementen 15 erreicht werden, so daß die Packungsdichte der Leadless Bauelemente auf der betreffenden Leiterplatte oder dergl. noch kleiner als bei
dem Ausführungsbeispiel nach den Fig. 1 bis 3 gemacht werden können.

Der Kontaktstift 9 nach den Fig. 5 und 5 A weist einen
Kontaktkopf 31 auf, der ebenfalls zunächst als rotationssymmetrischer Körper durch Drehen hergestellt, und
dann auf seiner Rückseite 39 wie der Kontaktkopf nach
den Fig. 4 und 4 A eben abgefräst wurde. Der wesentliche Unterschied des Kontaktkopfes 31 nach Fig. 5
und 5 A zu dem nach Fig. 4 und 4 A besteht darin, daß
der Kontaktkopf 31 nach den Fig. 5 und 5 A auf seiner
dem Schaft 30 benachbarten Seite eben ist und daß der Kontaktkopf sich von dieser ebenen Seite aus in Richtung auf sein freies Ende zu, wie dargestellt, stetig verjüngt, so daß am Übergang von der ebenen Fläche 40 zur schrägen Fläche 41 eine scharfe Randkante 42 besteht, mit der der Kontaktkopf 31 in der strichpunktierten Stellung, in welcher die Prüfung auf Fehlerfreiheit des Prüflings durchgeführt wird, mit dieser scharfen Randkante 42 an dem betreffenden Anschlußkontakt 14 anliegt. Hierdurch wird auch unter ungünstigen Umständen besonders guter elektrischer Kontakt zwischen dem Kontaktkopf 31 und dem vertikalen Steg 35 des Anschlußkontaktes 14 erreicht.

Die schräge Fläche 41 bildet während der Abwärtsbewegung des Kontaktstiftes 9 aus der in Fig. 5 voll ausgezogen dargestellten Stellung in die strichpunktierte Stellung eine zuerst mit dem Bauelement 15 in Kontakt kommende Leitfläche, die den Kontaktkopf 31 unter entsprechendem Ausbiegen des federnden Schaftes 30 bei der Abwärtsbewegung des Kontaktstiftes 9 so lange in vom Körper 16 wegführender Richtung nach außen lenkt, bis die scharfe Kante 42 mit dem Steg 35 in Kontakt kommt.

Der Kontaktstift 9 nach den Fig. 6 und 6 A unterscheidet sich von dem nach den Fig. 1 bis 3 im wesentlichen nur dadurch, daß sein Kontaktkopf 31 die Gestalt von zwei stumpf aneinander angesetzten Kegelstümpfen aufweist. Dieser Kontaktkopf 31 ist einstückig. Er weist infolge dieser Gestalt eine kreisförmige scharfe Kante 42 auf, die ebenfalls dem Kontaktieren von Anschlußkontakten von · Bauelementen dient.
und dieselben Vorteile wie die Randkante 42 des Kontaktkopfes 31 nach den Fig. 5 und 5 A bietet.

Die rotationssymmetrischen Kontaktköpfe nach den
Fig. 1 bis 3, 6 und 6 A haben gegenüber den nicht rotationssymmetrischen Kontaktköpfen 31 nach den Fig. 4
bis 5 A den Vorteil, daß man beim Einsetzen der Kontaktstifte 9 in eine Tragplatte 11 eines Prüfadapters
10 nicht auf die Winkelstellung des Kontaktstiftes
achten muß. Letzteres trifft auch auf den Kontaktstift 9 nach Fig. 10 zu.
Die in den Ausführungsbeispielen nach den Fig.7 bis 8 A
dargestellten beiden Kontaktstifte 9 sind nicht mehr
einstückig, sondern jeweils mehrteilig ausgebildet. Sie
weisen jeweils ein kreiszylindrisches Fußteil 32 mit
einem angeformten Ringbund 33 auf, wobei dieses Fußteil 32 und der Ringbund 33 dieselbe Aufgabe wie das
Fußteil 32 und der Ringbund 33 des Kontaktstiftes 9
nach den Fig. 1 bis 3 hat. In einen Schlitz des Fußteiles 32 ist in Fig. 7 und 7 A eine gerade Blattfeder rechteckförmigen Querschnittes eingesetzt, die
den Schaft 30 dieses Kontaktstiftes 9 bildet und die
an ihrem freien Endbereich auf der dem jeweils zu kontaktierenden Bauelement 15 zugewendeten Breitseite
einen angeschweißten oder angelöteten Kontaktkopf 31
aufweist, der hier kugelkalottenförmig ausgebildet ist, jedoch auch andere geeignete Ausbildung haben kann, bspw. eine oder mehrere scharfen Kanten zur Verbesserung des elektrischen Kontaktes mit den zu kontaktierenden Anschlußkontakten 14 aufweisen kann.

Auch bei dem Kontaktstift 9 nach den Fig. 8 und 8 A ist der Schaft 30 durch eine Blattfeder gebildet, die jedoch auch den Kontaktkopf 31 mit bildet, indem ihr freier Endbereich, wie dargestellt, V-förmig gebogen ist, wobei dieses "V", bezogen auf die Längsrichtung des Kontaktstiftes 9, querliegt. Hierdurch entsteht wiederum eine vorzugsweise scharfe Kante 42" und eine hier ebene schräge Leitfläche 41, die dieselben Aufgaben wie die scharfe Kante 42 und die Leitfläche 41 des Kontaktkopfes 31 nach den Fig. 5 und 5 A haben.

Der Kontaktstift 9 nach Fig. 9 weist einen Kontaktkopf 31 auf, der durch den freien Endbereich des Schaftes 30 gebildet ist. Dieser Schaft ist also an seinem freien Ende nicht verbreitert und bildet hier den Kontaktkopf 31. Damit dieser Kontaktkopf durch das Bauelement 15 unter Biegen des Schaftes 30 ausgelenkt werden kann, ist das gesamte Stirnende des Schaftes 30, wie dargestellt, als abgeschrägte Leitfläche 54, die hier eben ist, jedoch auch andere Gestalt, bspw. konvexe Gestalt haben kann, ausgebildet. Diese Leitfläche wirkt mit dem jeweiligen Bauelement 15 zum Ausbiegen des Schaftes 30 in von dem Körper 16 wegführender Richtung zusammen und hierdurch kann der Kontaktstift bei seiner Abwärtsbewegung bspw. in die strichpunktiert dargestellte Stellung gelangen, an der der Umfang des Schaftes 30 an der oberen Querkante der Vorderfläche 27 des Anschlußkontaktes 14 anliegt. Es ist auch möglich, daß in der unteren Endstellung des Kontaktstiftes nur die Fläche 54 am Anschlußkontakt 14 anliegt, was jedoch weniger günstig ist wegen der dann geringeren Auslenkung des Schaftes und den geringeren axialen Toleranzen. Dieser Kontaktstift 9 ist einstückig und der Schaft kann vorzugsweise rotationssymmetrisch, bspw. in vielen Fällen zweckmäßig kreiszylindrisch, sein. Dieser Kontaktstift 9 eignet sich insbesondere zum Kontaktieren von Bauelementen, deren Anschlußkontakte vom sie tragenden Körper seitlich abstehen, wie bei SMDs, SMCs, Flatpacks usw.

In den Ausführungsbeispielen nach den Fig. 1 bis 7,9 und 10 kontaktieren die Kontaktköpfe der Kontaktstifte die Anschlußkontakte auf ihren von dem sie jeweils tragenden Körper 16 abgewendeten,zu den jeweils benachbarten Umfangsflächen 18 des Körpers 16 ungefähr parallelen vertikalen Vorderseiten 27, und zwar in Höhe dieser vertikalen Umfangsflächen 18, was besonders vorteilhaft ist. Jedoch können ggfs. die Anschlußkontakte auch an anderen Stellen kontaktiert werden, wie es Fig. 8 an einem Beispiel zeigt. Der Kontaktkopf 31 wird bei der Abwärtsbewegung des Kontaktstiftes 9 durch das Auftreffen auf das jeweilige Bauelement 15 durch dieses in von dessen Körper 16 wegführende Richtung nach außen unter Biegen des Schaftes 30 bewegt. Doch ist es auch denkbar, in manchen Fällen die linke oder rechte Seite des Anschlußkontaktes 14, bspw. bei Fig. 7 die in die Bildebene fallende linke Seite 49 des dargestellten Anschlußkontaktes 14, durch den Kontaktkopf 31 zu kontaktieren, zu welchem Zweck der Kontaktstift 9 um 90° zu drehen ist und sein Kontaktkopf 31 vorzugsweise eine andere Gestalt erhält, bspw. schmaler oder bspw. gemäß Fig. 8 oder auf sonstige geeignete Weise ausgebildet sein kann.

In dem Ausführungsbeispiel nach den Fig. 1 bis 3 werden gleichzeitig alle Anschlußkontakte 14 des Bauelementes 15 gemäß diesem Ausführungsbeispiel der Erfindung durch die Kontaktstifte 9 zur Prüfung seitlich kontaktiert. Dies ist besonders zweckmäßig. Es ist jedoch auch möglich, vorzusehen, daß in manchen Fällen nicht alle Anschlußkontakte des Bauelementes in erfindungsgemäßer Weise durch erfindungsgemäß vorgesehene Kontaktstifte kontaktiert werden, sondern nur eine Teilanzahl oder im untersten Grenzfall nur ein Anschlußkontakt. Bspw. ist es denkbar, daß es Bauelemente gibt oder solche entwickelt werden, bei denen nicht alle Anschlußkontakte für die Durchführung des erfindungsgemäßen Verfahrens zugänglich sind.

Bei dem Kontaktstift 9 nach Fig. 9 kann auch auf einfache Weise oft zweckmäßig bspw. vorgesehen werden, daß der Kontaktkopf 31, damit er dicker ausgeführt sein kann, von einem kurzen, durch bogenförmige, strichpunktiert angedeutete Ausfräsungen 85 gebildeten verjüngten Bereich oder Schaft 30' getragen wird und dieser Kontaktkopf nicht oder nur wenig federnd gebogen werden kann. Dieser verjüngte Bereich 30' kann den Schaft allein oder einen Abschnitt des Schaftes 30 bilden.

Gemäß Fig. 11 kann man auch bei einem einen verbreiterten Kontaktkopf 31 aufweisenden Kontaktstift 9 den Schaft 30 durch mindestens eine Einschnürung 30''' leichter biegsam machen.

In den Ausführungsbeispielen ist durch die Pfeile A angedeutet, daß die Kontaktstifte 9 durch den Prüfadapter 10, an dem sie jeweils angeordnet sind, parallel zu ihren Längsrichtungen bzw. Längsachsen in gerader Richtung bewegt werden. Dies kann in vertikaler Richtung oder auch in anderen gewünschten Richtungen erfolgen.

Wenn anstelle des Prüfadapters 10 der Prüfling zur Kontaktierung durch die Kontaktstifte bewegt wird, gilt dann natürlich die Bewegungsrichtung des Prüflings 13. Wenn also vorstehend von Bewegungsrichtung des Prüfadapters gesprochen ist, ist je nach Sachlage hierunter auch die Bewegungsrichtung des Prüflings, die dem Kontaktieren durch Kontaktstifte dient, zu verstehen oder mit zu verstehen. Allgemein kann man von der Relativbewegungsrichtung zwischen Prüfadapter und Prüfling sprechen.

Die in den Fig. 1 - 9 und 11 dargestellten geraden Kontaktstifte 9 federn in geradem Zustand axial nicht, sondern sind nur elastisch biegsam. Wenn sie bereits etwas gebogen sind, können sie auch eventuellem Widerstand geringfügig elastisch nachgeben, was ihre Funktion nicht beeinträchtigt.

Bei dem in Fig. 10 dargestellten Kontaktstift 9 weist sein allseitig federnd biegsamer Schaft 30 auf einem kurzen, an den Ringbund 33 angrenzenden Bereich eine Schraubenfeder 86 auf, die in erster Linie starkes federndes Biegen des Schaftes 30 ermöglicht und zusätzlich auch axiales Federn des Schaftes 30 zur Verringerung der Härte axialer Stöße und damit zur Schonung des Kontaktkopfes 31 beim Auftreffen auf zu kontaktierende Bauelemente 15 ermöglichen kann. Jedoch liegt bei der Durchführung der Prüfung des jeweiligen Bauelementes 15 der Kontaktkopf 31, wie dargestellt, in Richtung des Pfeiles B seitlich ausgelenkt am betreffenden Anschlußkontakt 14 seitlich an und die in Richtung des Pfeiles C wirkende Rückstellkraft des federnd gebogenen Schaftes 30 drückt den Kontaktkopf 31 an den Anschlußkontakt 14 an und nicht die axiale Federkraft der Feder 86. Zweckmäßig kann auch der stangenartige Bereich 30" als hier gerade Biegefeder wirken, indem er elastisch und nicht vollständig unelastisch ist, was schon deshalb zweckmäßig ist, da wegen des geringen Durchmessers des bspw. zylindrischen oder sich verjüngenden oder sonstige Gestalt aufweisenden, vorzugsweise geraden Bereichs 30'' er zweckmäßig aus elastischem Metall bestehen kann, um der Gefahr plastischer Deformationen hierdurch auf einfache Weise zu begegnen. Es ist auch denkbar, daß man in manchen Fällen den Schaft in seiner gesamten Länge als Schraubenfeder ausbilden kann, die sich in Längsrichtung des Kontaktstiftes erstreckt oder die an anderer Stelle des Kontaktstiftes die federnde Auslenkung des Kontaktkopfes ermöglicht oder mit ermöglicht. Oft kann es auch zweckmäßig sein, daß das freie Ende dieser Schraubenfeder dann den Kontaktkopf tragen kann oder einen ihn tragenden Hals oder es kann auch in manchen Fällen das freie Ende dieser Schraubenfeder gleichzeitig den Kontaktkopf bilden. Um besonders hohe axiale Drucksteifigkeit einer solchen Schraubenfeder zu erreichen, gleichgültig, ob sie einen Abschnitt des federnden Schaftes 30 oder diesen federnden Schaft 30 im ganzen bildet, kann zweckmäßig vorgesehen sein, daß die Windungen der Schraubenfeder in entspanntem Zustand dieser Schraubenfeder, wie 86, aneinander anliegen oder fast aneinander anliegen. Die Feder 86 kann bspw. angeschweißt sein. Wenn der Schaft eine Schraubenfeder und/oder mindestens eine sonstige gekrümmte Biegefeder aufweist oder bildet, kann diese auch dazu dienen, daß versehentliches Kontaktieren der Oberseite des betreffenden Bauelementes durch den Kontaktstift diesen und das Bauelement nicht beschädigt. In diesem Fall ist dann entsprechend große axiale Zusammendrückbarkeit der betreffenden Feder bzw. Federn vorzusehen.

Anstatt der vorzugsweise geraden Relativbewegung zwischen dem Prüfadapter 10 und dem Prüfling 13 kann in manchen Fällen diese Relativbewegung auch zumindest teilweise nicht gerade sein.

Die Schraubenfeder 86 des Kontaktstiftes 9 nach Fig. 10 ist koaxial zum geraden Kontaktstift 9 angeordnet. Es können auch ggf. mehrere solcher Schraubenfedern am Kontaktstift angeordnet sein, wenn dies zur Erzielung bestimmter Federungseigenschaften erwünscht ist. Die Schraubenfeder kann eine zylindrische oder auch eine sonstige Schraubenfeder sein, bspw. eine Kegelfeder oder dgl.

Patentansprüche

1. Verfahren zum Kontaktieren von elektrischen oder elektronischen Bauelementen, vorzugsweise von Leadless Bauelementen, für Prüfzwecke mittels metallische elektrische Leitfähigkeit aufweisenden Kontaktstiften, die an einem Prüfadapter angeordnet sind, wobei die zu prüfenden Bauelemente seitlich zugängliche Anschlußkontakte aufweisen, d a d u r c h   g e k e n n z e i c h n e t , daß diese Anschlußkontakte des zu kontaktierenden Bauelementes durch am Prüfadapter in fester räumlicher Beziehung zueinander angeordnete Kontaktstifte seitlich kontaktiert werden, deren Längsrichtungen     in Richtung der für dieses Kontaktieren der Anschlußkontakte stattfindenden Relativbewegung zwischen dem Prüfadapter und dem Bauelement verlaufen   und deren Kontaktköpfe mittels sie aufweisenden oder tragenden elastisch biegsamen Schäften quer zur Richtung dieser Relativbewegung beweglich sind, so daß die Kontaktköpfe dieser Kontaktstifte bei der ihrem Positionieren auf den seitlich zugänglichen Anschlußkontakten des Bauelementes dienenden Relativbewegung   zwischen dem Prüfadapter und dem Bauelement durch das Bauelement unter elastischem Biegen der Kontaktstiftschäfte quer zur Richtung dieser Relativbewegung  . aus ihren Ruhestellungen ausgelenkt und durch die Elastizität dieser Schäfte an die Anschlußkontakte seitlich angedrückt werden.

2. Verfahren nach Anspruch 1, dadurch gekennzeichnet, daß das Bauelement vier Reihen von seitlich zugänglichen Anschlußkontakten aufweist und die Anschlußkontakte dieser vier Reihen gleichzeitig durch eine entsprechende Anzahl von am Prüfadapter zueinander richtungsgleich angeordneten Kontaktstiften seitlich kontaktiert werden.

3. Verfahren nach Anspruch 1 oder 2, dadurch gekennzeichnet, daß die Kontaktköpfe der Kontaktstifte bei der ihrer Positionierung auf den Anschlußkontakten eines Bauelementes dienenden Relativbewegung zwischen dem Prüfadapter und dem Bauelement in von dem die Anschlußkontakte tragenden Körper des Bauelementes wegführenden Richtungen bewegt werden.

4. Prüfadapter zur Durchführung des Verfahrens nach einem der vorhergehenden Ansprüche, dadurch gekennzeichnet, daß er mindestens eine dem seitlichen Kontaktieren der Anschlußkontakte (14) zur Prüfung der Bauelemente (15) dienende Anordnung von richtungsgleich angeordneten Kontaktstiften (9) aufweist, deren Längsrichtungen in Richtung (A) der vorzugsweise geraden Relativbewegung zwischen dem Prüfadapter (10) und den zu prüfenden Bauelementen (15) verlaufen und deren zum Inberührungkommen mit den Bauelementen bestimmten Kontaktflächen ihrer Kontaktköpfe (31) so ausgebildet sind, daß

diese Kontaktköpfe (31) beim Kontaktieren der zu
prüfenden Bauelemente durch diese unter elastischem
Biegen der Schäfte (30) der Kontaktstifte (9)
aus ihren Ruhestellungen in quer zu der genannten
Relativbewegungsrichtung (A) verlaufenden Richtungen
(B) auslenkbar sind.

5. Prüfadapter nach Anspruch 4, dadurch gekennzeichnet,
daß der federnd biegsame Schaft (30) des Kontaktstiftes in entspanntem Zustand gerade ist.

6. Prüfadapter nach Anspruch 4 oder 5, dadurch gekennzeichnet, daß die zum Inberührungskommen mit Bauelementen (15) vorgesehene Kontaktfläche des Kontaktkopfes (31) des Kontaktstiftes ein Abschnitt einer geometrischen
rotationssymmetrischen Fläche ist, deren Symmetrieachse mit der Längsachse des Schaftes (30) zusammenfällt.

7. Prüfadapter nach einem der Ansprüche 4 bis 6,
dadurch gekennzeichnet, daß der Kontaktkopf (31)
des Kontaktstiftes (9) über den an ihn angrenzenden
Bereich des Kontaktstiftes (9) zumindest in Richtung
auf zu kontaktierende Anschlußkontakte von Bauelementen übersteht, und daß vorzugsweise die
Kontaktfläche des Kontaktkopfes konvex gewölbt ist.

8. Prüfadapter nach einem der Ansprüche 4 bis 7, dadurch gekennzeichnet, daß der Kontaktkopf (31) des Kontaktstiftes (9) rotationssymmetrisch ist, vorzugsweise ungefähr oval, ellipsoidförmig oder kugelförmig ausgebildet ist.

9. Prüfadapter nach einem der Ansprüche 4 bis 8, dadurch gekennzeichnet, daß der Kontaktkopf (31) des Kontaktstiftes (9) durch einen Endabschnitt des Schaftes (30) gebildet ist, der zumindest eine zum Biegen des Schaftes mit dem jeweils zu kontaktierenden Bauelement (15) zusammenwirkende Fläche (54) aufweist (Fig. 9).

10. Prüfadapter nach einem der Ansprüche 4 bis 9, dadurch gekennzeichnet, daß die Kontaktstifte (9) der dem Kontaktieren des Bauelementes dienenden Kontaktstiftanordnung unter sich gleich ausgebildet und/oder einstückig sind.

11. Prüfadapter nach einem der Ansprüche 4 bis 10, dadurch gekennzeichnet, daß zumindest der Schaft (30) des Kontaktstiftes (9) rotationssymmetrisch ist und/ oder daß der Schaft (30) sich in Richtung auf den Kontaktkopf (31) zu durchgehend oder auf mindestens einem Teil der Länge des Schaftes verjüngt.

5334

12. Prüfadapter nach einem der Ansprüche 4 bis 11, dadurch gekennzeichnet, daß der Schaft (30) des Kontaktstiftes (9) eine Blattfeder oder eine Schraubenfeder (86) aufweist oder durch eine Blatt- oder Schraubenfeder gebildet ist, an der der Kontaktkopf angeordnet ist, oder daß der Kontaktkopf durch einen freien Endbereich der Blatt- oder Schraubenfeder gebildet ist und daß der Kontaktstift (9) vorzugsweise einen Halter (32) für die Schrauben- oder Blattfeder (30) aufweist.

13. Prüfadapter nach einem der Ansprüche 4 bis 12, dadurch gekennzeichnet, daß der Kontaktstift (9) ein an den Schaft (30) direkt oder über einen Ringbund (33) anschließendes zylindrisches Fußteil (32) aufweist, das in eine Aufnahmebohrung (12) einer Tragplatte (11) des Prüfadapters (10) formschlüssig eingesetzt ist.

14. Prüfadapter nach einem der Ansprüche 4 bis 13, dadurch gekennzeichnet, daß der Kontaktstift (9) aus Metall besteht und die Härte seines Schaftes vorzugsweise 300 bis 500 HV beträgt.

15. Prüfadapter nach einem der Ansprüche 4 bis 14, dadurch gekennzeichnet, daß der Kontaktkopf des Kontaktstiftes mindestens eine Kante (42; 42''), vorzugsweise eine scharfe Kante (42; 42") aufweist, die dem Anliegen an Anschlußkontakten (14) von Bauelementen (15) in der der jeweiligen Prüfung dienenden Stellung des Kontaktkopfes (31) dient.

16. Prüfadapter nach einem der Ansprüche 4 bis 15, dadurch gekennzeichnet, daß der Kontaktstift eine die federnde Auslenkbarkeit des Kontaktkopfes (31) bewirkende oder mit unterstützende Schraubenfeder (86) und/oder eine sonstige gekrümmte Biegefeder aufweist, die vorzugsweise auch axiale Federung des Kontaktkopfes bewirkt bzw. bewirken.

17. Prüfadapter nach einem der Ansprüche 4 bis 16, dadurch gekennzeichnet, daß der Schaft (30) des Kontaktstiftes (9) durchgehend oder an mindestens einer Stelle eine biegsame Feder, vorzugsweise eine Biegefeder bildet.

18. Kontaktstift für einen Prüfadapter nach einem der Ansprüche 4 bis 17, dadurch gekennzeichnet, daß der Kontaktstift (9) wie in einem der Ansprüche 4 bis 17 beschrieben ausgebildet ist.

FIG.1

FIG.2

FIG3

0194695

2/3

FIG.4

FIG.4A

FIG.5

FIG.5A

FIG.6

FIG.6A

0194695

3/3

FIG.11

FIG.7

FIG.7A

FIG.8

FIG.8A

FIG.9

FIG.10

**0194695**

Nummer der Anmeldung

**Europäisches Patentamt**

# EUROPÄISCHER RECHERCHENBERICHT

## EINSCHLÄGIGE DOKUMENTE

EP 86103428.8

| Kategorie | Kennzeichnung des Dokuments mit Angabe, soweit erforderlich, der maßgeblichen Teile | Betrifft Anspruch | KLASSIFIKATION DER ANMELDUNG (Int Cl⁴) |
|---|---|---|---|
| X | <u>DE - A1 - 2 907 953</u> (TEKTRONIX) | 1-5,10, 12-18 | G 01 R 1/073 |
| A | * Fig. 2,3; Seite 7, letzter Absatz - Seite 8, erster Absatz * | 6-9,11 | G 01 R 31/28 |

---

|  | RECHERCHIERTE SACHGEBIETE (Int. Cl.4) |
|---|---|
|  | G 01 R 1/00 |
|  | G 01 R 31/00 |
|  | H 01 R 11/00 |
|  | H 01 L 21/00 |

Der vorliegende Recherchenbericht wurde für alle Patentansprüche erstellt.

| Recherchenort | Abschlußdatum der Recherche | Prüfer |
|---|---|---|
| WIEN | 18-06-1986 | KUNZE |